# EUROPEAN PATENT APPLICATION

(11) **EP 4 518 150 A1**
(43) Date of publication of application: **05.03.2025**
(21) Application number: 24196364.4
(22) Date of filing: 26.08.2024
(51) Int. Cl.: H03F 1/02, H03F 1/32, H03F 3/195, H03F 3/30, H03F 3/72

(54) **UNIT AMPLIFICATION CIRCUIT, AMPLIFIER AND RECEIVING CIRCUIT**

(30) Priority: 01.09.2023 KR 20230116330; 16.01.2024 KR 20240006768
(71) Applicant: Samsung Electronics Co., Ltd, Suwon-si, Gyeonggi-do 16677 (KR)
(72) Inventor: YOO, Heeyong, 16677 Suwon-si (KR); PARK, Beomyu, 16677 Suwon-si (KR); KANG, Byoungjoong, 16677 Suwon-si (KR); BAE, Jeongyeol, 16677 Suwon-si (KR); SUH, Bosung, 16677 Suwon-si (KR); YOO, Sangmin, 16677 Suwon-si (KR); LEE, Jongsoo, 16677 Suwon-si (KR)
(74) Representative: Marks & Clerk LLP

(57) **Abstract**

A unit amplification circuit includes a push-pull circuit having a transistor with a gate connected to an input terminal, a symmetrical circuit connected symmetrically to the push-pull circuit and configured to be turned off in a first operation mode and turned on in a second operation mode, and a path control circuit connected to a drain of the transistor and configured to connect the drain and an output terminal in the first operation mode and to disconnect the drain and the output terminal in the second operation mode.

## Description

### Technical Field

Example embodiments relate to a unit amplification circuit, an amplifier, and a receiving circuit.

### Discussion of Related Art

Electronic devices, supporting wireless communication technologies including Wi-Fi and Bluetooth, may be equipped with a radio-frequency integrated chip (RFIC). An RFIC may include a transmitting circuit for transmitting an RF signal and a receiving circuit for receiving an RF signal. For example, the power consumption of the receiving circuit may have a significant impact on the overall power consumption of the electronic device. Therefore, low-power design of an RFIC receiving circuit may be required to reduce battery consumption of the electronic device and increase day-of-usage (DOU).

### SUMMARY

Example embodiments provide a unit amplification circuit having improved amplification-related characteristics, an amplifier, and a receiving circuit.

According to an example embodiment, a unit amplification circuit includes a push-pull circuit having a transistor with a gate connected to an input terminal, a symmetrical circuit connected symmetrically to the push-pull circuit and configured to be turned off in a first operation mode and turned on in a second operation mode, and a path control circuit connected to a drain of the transistor and configured to connect the drain and an output terminal in the first operation mode and to disconnect the drain and the output terminal in the second operation mode.

According to an example embodiment, an amplifier includes a plurality of unit amplification circuits, each configured to operate with a respective gain in a first operation mode and with a different respective gain in a second operation mode. Each of the plurality of unit amplification circuits may include a push-pull circuit having a transistor with a gate connected to an input terminal, a symmetrical circuit connected symmetrically to the push-pull circuit and configured to be turned off in the first operation mode and turned on in the second operation mode, and a path control circuit connected to a drain of the transistor and configured to connect the drain to an output terminal in the first operation mode and to disconnect the drain from the output terminal in the second operation mode.

According to an example embodiment, a receiving circuit includes an amplifier configured to amplify a receive signal through a plurality of unit amplification circuits, each configured to operate with a respective gain in a first operation mode and with a different respective gain in a second operation mode, a mixer configured to convert the receive signal into a baseband signal through a local oscillator (LO) signal, and an analog baseband filter configured to filter the baseband signal. Each of the plurality of unit amplification circuits may include a push-pull circuit having a transistor with a gate to which the receive signal is applied, a symmetrical circuit connected symmetrically to the push-pull circuit and configured to be turned off in the first operation mode and turned on in the second operation mode; and a path control circuit connected to a drain of the transistor and configured to connect the drain and the mixer in the first operation mode and to disconnect the drain and the mixer in the second operation mode.

According to an example embodiment, a unit amplification circuit is configured to operate in an amplification mode and a deactivation mode. The unit amplification circuit includes: a push-pull circuit comprising first and second transistors, each having a gate that is alternating current (AC) coupled to an input terminal, and each having a pair of conducting terminals; a symmetrical circuit connected symmetrically to the push-pull circuit and configured to be turned off in the amplification mode and turned on in the deactivation mode; and a path control circuit connected to the first and second transistors and configured to close respective circuit paths between one of the pair of conducting terminals of each of the first and second transistors to an output terminal in the amplification mode, and to open the respective circuit paths in the deactivation mode.

A symmetrical circuit may comprise a circuit which has symmetry of its components about a line at a midpoint of the circuit. A symmetrical connection (or connected symmetrically) may comprise a connection between two circuits (or components) such that there is symmetry of the components of the two circuits (or symmetry of the connected components themselves) about a line at the connection. The connection may comprise a plurality of connection points.

At least some of the above and other features of the disclosure are set out in the claims.

### BRIEF DESCRIPTION OF DRAWINGS

The above and other aspects, features, and advantages of the present disclosure will be more clearly understood from the following detailed description, taken in conjunction with the accompanying drawings.
FIG. 1 is a diagram illustrating a unit amplification circuit according to some example embodiments.
FIGS. 2A and 2B are detailed circuit diagrams of the unit amplification circuit of FIG. 1 according to some example embodiments.
FIG. 3 is a diagram illustrating the unit amplification circuit in a first operation mode according to some example embodiments.
FIG. 4 is a diagram illustrating the unit amplification circuit in a second operation mode according to some example embodiments.
FIG. 5 is a diagram illustrating a unit amplification circuit according to some example embodiments.
FIG. 6 is a diagram illustrating a unit amplification circuit having a common source structure according to some example embodiments.
FIG. 7 is a diagram illustrating a unit amplification circuit having a cascade structure according to some example embodiments.
FIG. 8 is a diagram illustrating an amplifier according to some example embodiments.
FIG. 9 is a diagram illustrating an amplification stage according to some example embodiments.
FIGS. 10 and 11 are diagrams illustrating comparison of parameters S11 of an amplifier according to some example embodiments.
FIG. 12 is a diagram illustrating comparison of IIP3 parameters of an amplifier according to some example embodiments.
FIG. 13 is a table illustrating power consumption of an amplifier according to some example embodiments.
FIG. 14 is a diagram illustrating a wireless communication device according to some example embodiments.

### DETAILED DESCRIPTION

Hereinafter, example embodiments will be described with reference to the accompanying drawings.

Herein, when a first electrical component is said to be "connected" to a second electrical component or a circuit node, one example of the connection is a direct electrical connection with no intervening electrical components (with the exception of wiring or interconnects), e.g., as may be illustrated in a corresponding schematic diagram herein. However, an indirect connection in which one or more intervening components is present may be available in other embodiments, if the indirect connection would not be inconsistent with the functionality of the overall circuit achieved with the direct connection.

Herein, for brevity, after a component is first introduced with a name followed by a label, the component may be later referred to with a shortened version of the name followed by the label. For example, "a first N-type transistor MN1" may be subsequently referred to as "transistor MN1".

A unit amplification circuit according to some example embodiments to be described below may refer to a single amplification cell or a transconductance cell. A plurality of such single cells may be connected in parallel to form a composite amplifier such as a low noise amplifier (LNA) of a receiver. In embodiments of the inventive concept such as those described below, each single cell may be individually controlled to be turned on in an amplification mode of that cell, and to be turned off in a deactivation mode of that cell. Deactivation of one or more of the single cells may be individually implemented to lower the gain of the composite amplifier when lower gain is acceptable for a desired performance in a corresponding communication environment. When deactivated, the single cell may consume negligible power or substantially less power than when activated, resulting in less power consumed by the composite amplifier. Embodiments of the inventive concept may exhibit other performance advantages in the deactivation mode as compared to conventional circuits, as described below. These may include reduced power consumption, reduced feedback of high frequency components that otherwise cause nonlinearity when flowing towards another unit amplification circuit, and better matching of input impedance and output impedance with external interfacing components.

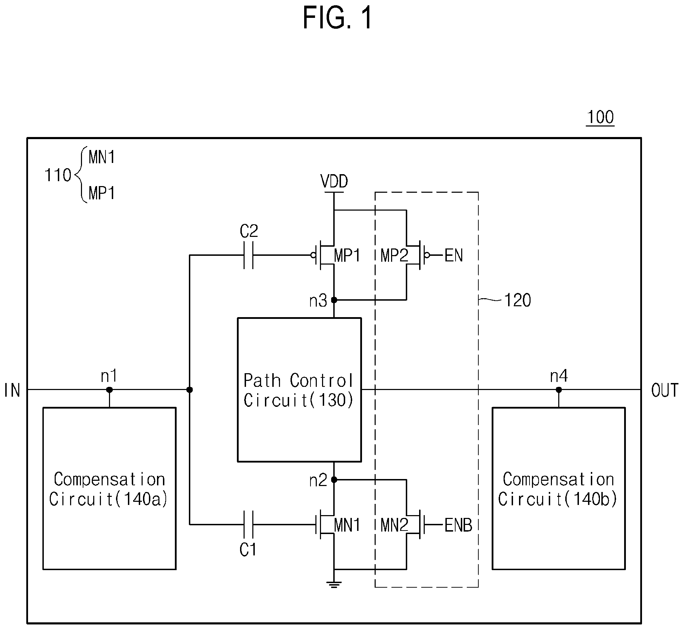

FIG. 1 is a diagram illustrating a unit amplification circuit, 100, according to some example embodiments. The unit amplification circuit 100 may include a push-pull circuit 110, a symmetrical circuit 120, and a path control circuit 130.

The push-pull circuit 110 may be configured to perform a push operation to output an output signal OUT at a high level or a pull operation to output an output signal OUT at a low level, depending on an input signal IN at an input terminal.

The push-pull circuit 110 may include a first N-type transistor MN1 and a first P-type transistor MP1, each having a gate connected to the input terminal through a first node n1. Herein, each transistor described as having a gate is a Field Effect Transistor (FET) that also has a pair of "conducting terminals", i.e., a source and a drain. Transistor MN1 may have a gate connected to the input terminal through a first capacitor C1, a source grounded, and a drain connected to the path control circuit 130 through a second node n2. Transistor MP1 may have a gate connected to the input terminal through a second capacitor C2, and may be supplied with a supply voltage VDD from a source of transistor MP1. Transistor MP1 may have a drain connected to the path control circuit 130 through a third node n3.

When an input signal IN is applied through the first node n1, the first capacitor C1 connected to the gate of transistor MN1 may AC-couple the applied input signal IN. Similarly, when the input signal IN is applied through the first node n1, the second capacitor C2 connected to the gate of transistor MP1 may AC-couple the applied input signal IN.

Either transistor MN1 or transistor MP1 may be turned on depending on the magnitude of the input signal IN. When transistor MN1 is turned on, the push-pull circuit 110 may perform a pull operation. When transistor MP1 is turned on, the push-pull circuit 110 may perform a push operation.

Due to the above-described structure, the push-pull circuit 110 may boost transconductance based on current reuse. For example, the same current flows through the second node n2 and the third node n3 of the push-pull circuit 110. Accordingly, transconductance of an amplification circuit may be twice the transconductance of each of transistor MN1 and transistor MP1.

The symmetrical circuit 120 may be symmetrically connected to the push-pull circuit 110 and configured to be turned off in a first operation mode and turned on in a second operation mode. Hereinafter, the first operation mode may be defined as an amplification mode in which the unit amplification circuit 100 performs an amplification operation when it is turned on (or activated), and the second operation mode may be defined as a deactivation mode in which the unit amplification circuit 100 is turned off (or deactivated). In general, the unit amplification circuit 100 may be considered to have a first gain in the first operation mode, and may have a different gain (e.g., zero gain) in the second operation mode. Note that even though the unit amplification circuit 100 may be turned off, the second operation mode may still be considered an "operation mode" because some of the transistors may be turned on to prevent the output of any amplified signal and other transistors may be turned on for impedance matching, described below.

The symmetrical circuit 120 may include a second N-type transistor MN2 and a second P-type transistor MP2. Transistor MN2 may be symmetrically connected to transistor MN1 and may be turned off in the first operation mode and turned on in the second operation mode. Similarly, transistor MP2 may be symmetrically connected to transistor MP1 and may be turned off in the first operation mode and turned on in the second operation mode.

Transistor MN2 being symmetrically connected to transistor MN1 may mean that the drain of transistor MN2 is connected to the second node n2 and the source thereof is grounded. Also, transistor MP2 being symmetrically connected to transistor MP1 may mean that a drain of transistor MP2 is connected to the third node n3 and the source thereof is supplied with a supply voltage VDD.

Complementary signals may be applied to the gates of transistors MN2 and MP2 such that transistors MN2 and MP2 are commonly turned off in the first operation mode and commonly turned on in the second operation mode. For example, transistor MP2 may be applied with an enable signal EN having a high level in the first operation mode, and transistor MN2 may be applied with an enable bar signal ENB having a logic level, opposite to the logic level of the enable signal EN (for example, a low level) in the first operation mode.

As each transistor MP2 and MN2 is turned on in the second operation mode, the symmetrical circuit 120 may ground transistor MN1, and may short-circuit the drain to the source of transistor MP1 through transistor MN2 and transistor MP2 in an analog manner. For example, in the second operation mode, the symmetrical circuit 120 may be configured to ground the drain of transistor MN1 to ground GND and connect the drain of transistor MP1 to the supply voltage VDD (by short-circuiting the drain to the source of transistor MP1)..

When the unit amplification circuit 100 is turned off, for example, in the second operation mode, a path to an output terminal may be blocked through the path control circuit 130, but the input signal IN may still be applied. When the input signal IN is applied to transistor MN1 and transistor MP1, nonlinear signal components caused by nonlinearity of a transistor may be fed back to an input terminal. For example, the nonlinear components may be fed back to the input terminal through a parasitic capacitance component of each transistor MN1, MP1. According to some example embodiments, when the drains of transistor MN1 and transistor MP1 are shorted to their respective sources through the symmetrical circuit 120 in an analog manner, a nonlinear signal component caused by each transistor may also leak to source voltage VDD or ground GND.

Accordingly, the influx of nonlinear components of the input signal IN, which occurs when the unit amplification circuit 100 is turned off, and/or the feeding back of nonlinear components to the input terminal and flow thereof to another unit amplification circuit (forming a composite amplifier with the unit amplification circuit 100) may be prevented by the symmetrical circuit 120.

The path control circuit 130 may be connected to a drain of a transistor within the push-pull circuit 110, and may be configured to connect or disconnect a path between the push-pull circuit 110 and an output terminal (for example, the fourth node n4) at which the output signal OUT is output, depending on an operation mode. For example, the path control circuit 130 may be connected to the second node n2 connected to the drain of transistor MN1 and the third node n3 connected to the drain of transistor MP1.

The path control circuit 130 may be configured to connect a drain of a transistor (e.g., transistor MP1 or MN1) of the push-pull circuit 110 and the output terminal, the fourth node n4, in the first operation mode and to disconnect the drain of the transistor of the push-pull circuit 110 from the output terminal, the fourth node n4, in the second operation mode.

For example, the path control circuit 130 disconnecting the drain of the push-pull circuit 110 from the output terminal in the second operation mode may mean that a path, through which unnecessary DC current flows to the output terminal, is blocked when the unit amplification circuit is turned off. Accordingly, unnecessary power consumption may be prevented through the path control circuit 130 when the unit amplification circuit is in an OFF state.

According to some example embodiments, the unit amplification circuit may further include a first compensation circuit 140a and a second compensation circuit 140b.

The first compensation circuit 140a may be connected to an input terminal (for example, the first node n1) and configured to compensate for an impedance change, defined at the input terminal, from an input impedance in the first operation mode to a different input impedance in the second operation mode. The second compensation circuit 140b may be connected to an output terminal (for example, the fourth node n4) and configured to compensate for an impedance change, defined at the output terminal, from an output impedance in the first operation mode to a different output impedance in the second operation mode.

When the unit amplification circuit is turned off, its input impedance and output impedance may change. For example, amplification is not performed in the second operation mode (gain is zero) as described above, so that Miller capacitance may be lost or eliminated. For example, the input capacitance (and/or the output capacitance) may also change depending on a change in the gate-source voltage of transistor MN1 and transistor MP1.

Each of the first compensation circuit 140a and the second compensation circuit 140b may internally have a capacitor that may be activated in the second operation mode (but not in the first operation mode) to compensate for the change in input impedance and output impedance that occurs as the above-described unit amplification circuit is turned off.

According to the above-described embodiments, the unit amplification circuit may compensate for the impedance change caused by turning off, which can improve the impedance matching characteristics. In addition, the unit amplification circuit may block a DC current path of the push-pull circuit 110 to reduce unnecessary power consumption, and may block the feedback of nonlinear components to significantly reduce linearity degradation.

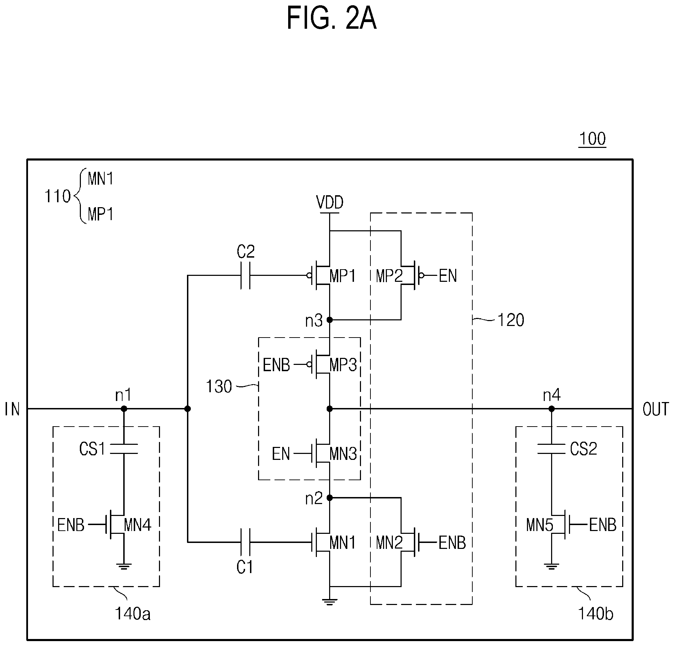

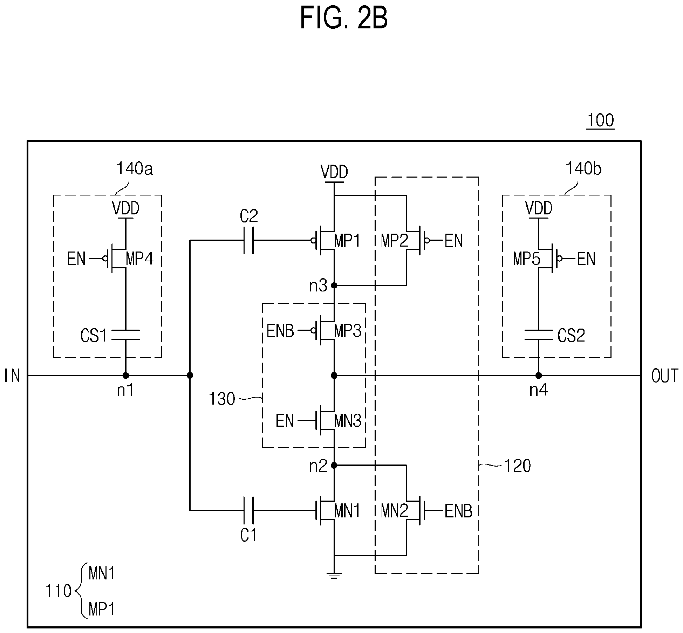

FIGS. 2A and 2B are detailed circuit diagrams of the unit amplification circuit of FIG. 1 according to some example embodiments.

Referring to FIG. 2A, according to some example embodiments, the path control circuit 130 may include a third N-type transistor MN3 and a third P-type transistor MP3. Transistor MN3 may have a source connected to the drain of transistor MN1 and may be turned on in the first operation mode and turned off in the second operation mode. Transistor MP3 may have a source connected to the drain of transistor MP1 and may be turned on in the first operation mode and turned off in the second operation mode.

For example, transistor MN3 may have a drain connected to the fourth node n4 and a source connected to the second node n2. In addition, transistor MP3 may have a drain connected to the fourth node n4 and a source connected to the third node n3. Accordingly, a path between the second node n2 and the fourth node n4 may be blocked when transistor MN3 is turned off, and a path between the third node n3 and the fourth node n4 may be blocked when transistor MP3 is turned off.

An enable signal EN having a high level in the first operation mode may be applied to the gate of transistor MN3, and an enable bar signal ENB may be applied to the gate of transistor MP3. Accordingly, transistor MN3 and transistor MP3 are turned off by the enable signal EN and the enable bar signal ENB in the second operation mode to prevent unnecessary DC current from flowing to an output terminal.

According to some example embodiments, the first compensation circuit 140a may include a first compensation capacitor CS1 and a first compensation transistor MN4. Capacitor CS1 may be connected to an input terminal. Capacitor CS1 may compensate for a change in input impedance from a first input impedance when the unit amplification circuit 100 is turned on to a second input impedance when the unit amplification circuit is turned off, according to the above-described embodiments. For example, capacitor CS1 may have a value to compensate for the change in input capacitance caused by Miller capacitance and/or the change in gate-source voltage of a transistors of the push-pull circuit 110.

The first compensation transistor MN4 may have a drain connected to capacitor CS1 and a source connected to ground. An enable bar signal ENB may be applied to the gate of transistor MN4. Accordingly, transistor MN4 may be turned off in the first operation mode and turned on in the second operation mode, depending on the enable bar signal ENB.

When transistor MN4 is turned on in the second operation mode, the first compensation capacitor CS1 may be connected to the first node n1 and GND and may compensate for the change in input impedance.

According to some example embodiments, a second compensation circuit 140b may include a second compensation capacitor CS2 and a second compensation transistor MN5. Capacitor CS2 may be connected to an output terminal and may compensate for the change in output impedance from a first output impedance when the unit amplification circuit 100 is turned on, to a second output impedance when the unit amplification circuit 100 is turned off, according to the above-described embodiments. For example, capacitor CS2 may have a value to compensate for the change in output capacitance caused by Miller capacitance and/or the change in gate-source voltage of the transistors of the push-pull circuit 110.

The second compensation transistor MN5 may have a drain connected to the second compensation capacitor CS2 and a source connected to ground. Transistor MN5 may have a gate supplied with an enable bar signal ENB. Accordingly, transistor MN5 may be turned off in the first operation mode and turned on in the second operation mode.

When transistor MN5 is turned on in the second operation mode, capacitor CS2 may be connected to the fourth node n4 and GND and may compensate for the change in output impedance.

Referring to FIG. 2B, the unit amplification circuit 100 of FIG. 2B may have the same configuration as illustrated FIG. 2A except for the first compensation circuit 140A and the second compensation circuit 140B.

In the case of the first compensation circuit 140a, the first compensation transistor MP4 included in the first compensation circuit 140a may be implemented as a P-type transistor. For example, transistor MP4 may have a drain connected to capacitor CS1 and a source supplied with a supply voltage VDD. Transistor MP4 may have a gate supplied with an enable signal EN. Accordingly, transistor MP4 may be turned off in the first operation mode and turned on in the second operation mode, depending on the enable signal EN.

In the case of the second compensation circuit 140b, the second compensation transistor MP5 included in the second compensation circuit 140b may also be implemented as a P-type transistor. For example, the second compensation transistor MP5 may have a drain connected to the first compensation capacitor CS1 and a source supplied with a supply voltage VDD. Transistor MP5 may have a gate supplied with an enable signal EN. Accordingly, transistor MP5 may be turned off in the first operation mode and turned on in the second operation mode, depending on the enable signal EN.

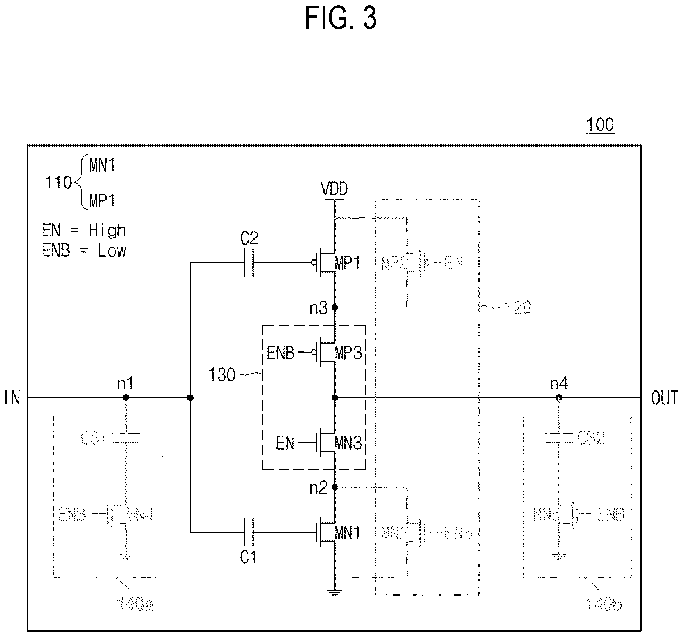

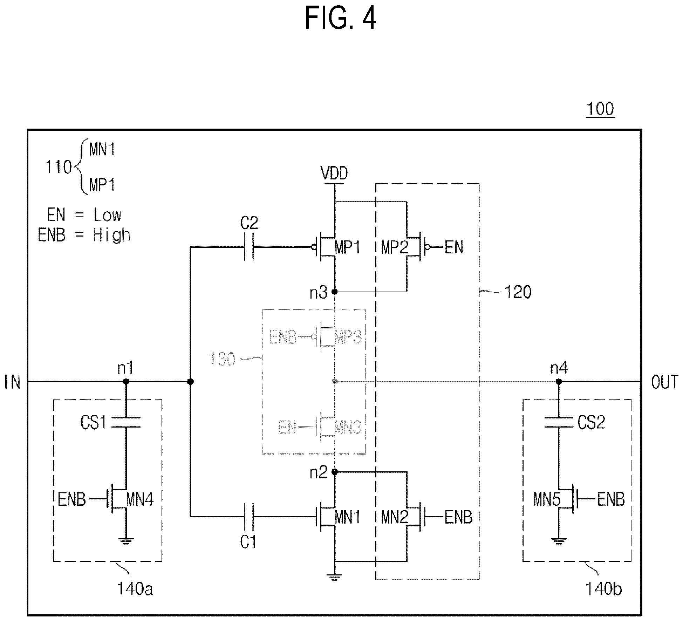

For ease of description, FIGS. 3 and 4 are drawn with reference to FIG. 2A, but example embodiments are not limited thereto. For example, each compensation circuit may be configured based on FIGS. 2A and 2B.

FIG. 3 is a diagram illustrating the unit amplification circuit in a first operation mode according to some example embodiments.

Referring to FIG. 3, in the first operation mode, the enable signal EN may be applied with a logic high level and the enable bar signal ENB may be applied with a logic low level. Accordingly, transistor MN3 and transistor MP3, each having a gate applied with a high-level signal, may be turned on. Also, transistor MN2, transistor MP2, the first compensation transistor MN4, and the second compensation transistor MN5, each having a gate applied with a low-level signal, may be turned off.

The path control circuit 130 including the turned-on transistor MN3 and transistor MP3 may provide an output path from the second node n2 and the third node n3 to the fourth node n4 to the push-pull circuit 110. Accordingly, the push-pull circuit 110 may amplify the input signal IN applied to the input terminal in the first operation mode, and the amplified output signal OUT may be output to the fourth node n4. For example, the push-pull circuit 110 may amplify the input signal IN depending on the AC-coupled input signal IN through the first capacitor C 1 or the second capacitor C2 while performing a push or pull operation.

FIG. 4 is a diagram illustrating the unit amplification circuit in a second operation mode according to some example embodiments.

Referring to FIG. 4, in the second operation mode, the enable signal EN may be applied with a logic low level and the enable bar signal ENB may be applied with a logic high level. Accordingly, transistor MN3 and transistor MP3, each having a gate applied with a low-level signal, may be turned off. Also, transistor MN2, transistor MP2, the first compensation transistor MN4, and the second compensation transistor MN5, each having a gate applied with a high-level signal, may be turned on.

The path control circuit 130 including the turned-off transistors MN3 and MP3 may block an output path from the second node n2 and the third node n3 to the fourth node n4. Accordingly, DC current that may be generated in the push-pull circuit 110 in the second operation mode may be prevented from flowing into the output terminal, and power consumption caused by the flowing DC current may be prevented.

The symmetric circuit 120 including the turned-on MN2 and MP2 may provide an analog ground to the push-pull circuit 110. For example, transistor MN2 may ground the drain of transistor MN1 as transistor MN2 is turned on, and transistor MP2 may connect the drain of transistor MP1 to a terminal of the supply voltage VDD when transistor MP2 is turned on. Accordingly, nonlinear components that may arise when the input signal IN is applied to transistor MN1 and transistor MP1 may flow to ground or supply voltage through the symmetric circuit 120, so that the nonlinear components may be prevented from flowing into the input terminal through parasitic components.

The first compensation circuit 140a including the turned-on first compensation transistor MN4 may compensate for an input impedance change of the unit amplification circuit 100 in the second operation mode (i.e., the change in input impedance that otherwise would occur from the first to the second operation mode). For example, when transistor MN4 is turned on, capacitor CS1 connected to the first node n1 may provide an impedance for input impedance compensation to the unit amplification circuit 100. In addition, when transistor MN5 is turned on, capacitor CS2 connected to the fourth node n4 may provide an impedance for output impedance compensation to the unit amplification circuit 100. For example, even when input capacitance and/or output capacitance decreases as the unit amplification circuit 100 is turned off in the second operation mode, the capacitance may be compensated for through the first compensation circuit 140a and the second compensation circuit 140b. Therefore, the impedance of the unit amplification circuit 100 may be maintained constant.

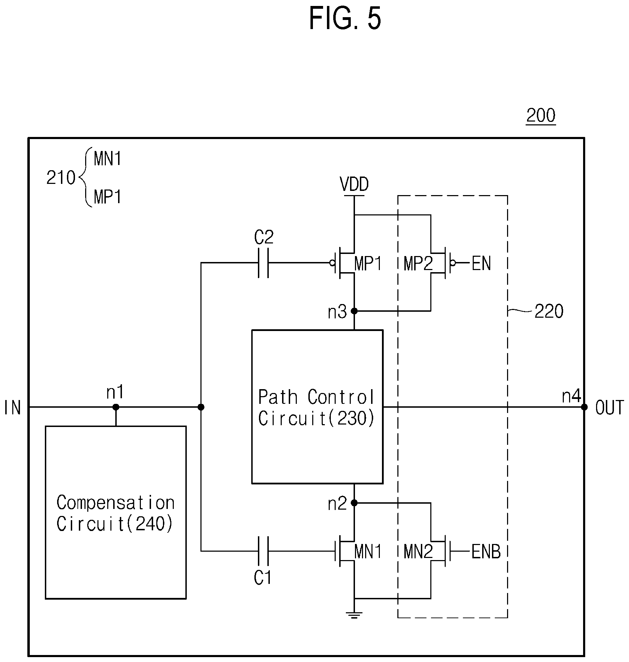

FIG. 5 is a diagram illustrating a unit amplification circuit according to some example embodiments.

Referring to FIG. 5, the unit amplification circuit 200 according to some example embodiments may be implemented without the second compensation circuit connected to the fourth node illustrated in FIG. 1 and FIG. 2A. For example, the unit amplification circuit 200 may include a push-pull circuit 210, a symmetric circuit 220, a path control circuit 230, and a first compensation circuit 240.

According to examples of implementing the unit amplification circuit 200, a change in input impedance may be relatively larger than a change in output impedance. In an example embodiment, as illustrated in FIG. 5, impedance change compensation of the unit amplification circuit 200 may be sufficiently achieved by adding the first compensation circuit 240 to an input terminal, a first node, without an additional element for compensating the change in output impedance on an output terminal.

Even when the first compensation circuit 240 is provided but a second compensation circuit is not provided, the unit amplification circuit 200 may operate in the same manner as described in FIG. 1 or FIG. 2A to FIG. 4. For example, in a first operation mode, transistor MN2 and transistor MP2 included in the symmetric circuit 220 may be turned off when a high-level enable signal EN is applied. Also, the path control circuit 230 may be configured to connect drains of transistor MN1 and transistor MP1 included in the push-pull circuit 210 to a fourth node n4, an output terminal. For example, the path control circuit 230 may operate according to FIG. 2A to FIG. 3 described above. The first compensation circuit 240 may be deactivated in the first operation mode.

For example, in the second operation mode, the second N-type transistor MN2 and transistor MP2 may be turned on when a low-level enable signal EN is applied. Accordingly, nonlinear components that may arise in the push-pull circuit 210 due to the input signal IN may flow to the ground. The path control circuit 230 may block a path between the push-pull circuit 210 and the output terminal. The first compensation circuit 240 may operate to compensate for a capacitance change in the second operation mode in which amplification is not performed, or a capacitance change depending on a change in gate-source voltage of a transistor of the push-pull circuit 210. For example, the first compensation circuit 240 may operate according to FIG. 2A, FIG. 2B, and FIG. 4 described above.

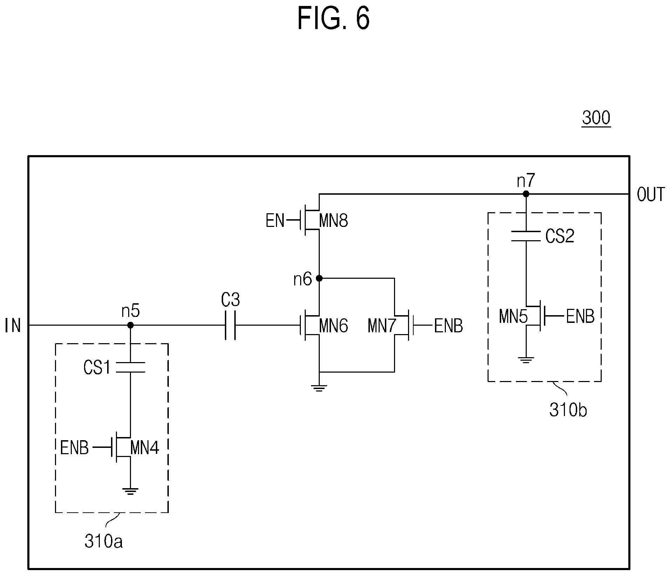

FIG. 6 is a diagram illustrating a unit amplification circuit having a common source structure according to some example embodiments.

Referring to FIG. 6, a unit amplification circuit 300 may be implemented with a common source structure rather than the push-pull structure according to FIG. 1 to FIG. 5 described above. In an example embodiment, the unit amplification circuit 300 may include fourth N-type transistor MN4 to the fifth N-type transistor MN5, a first compensation circuit 310a, and a second compensation circuit 3 10b, as illustrated.

A sixth N-type transistor MN6 may have a gate, connected to an input terminal, a fifth node n5, through a third capacitor C3, and a source grounded. The third capacitor C3 may be connected between the fifth node n5 and the gate of the sixth N-type transistor MN6 for AC coupling of the input signal IN. The drain of the sixth N-type transistor MN6 may be connected to a drain of a seventh N-type transistor MN7 and a source of an eighth N-type transistor MN8 through a sixth node n6.

The sixth N-type transistor MN6 may amplify the input signal IN in the first operation mode.

Transistor MN7 may be symmetrically connected to transistor MN6. For example, the drain of transistor MN7 may be connected to the sixth node n6 and a source of transistor MN7 may be grounded. An enable bar signal ENB may be applied to a gate of transistor MN7.

Transistor MN7 may be turned off in the first operation mode and turned on in the second operation mode, depending on the enable bar signal ENB applied to the gate of transistor MN7. Accordingly, in the second operation mode, transistor MN7 may be turned on to provide an "analog ground" to the sixth N-type transistor MN6. For example, transistor MN7 may be turned on to ground the drain of transistor MN6. Accordingly, the nonlinear components that may arise when the input signal IN is applied to transistor MN6 may flow through a symmetric circuit to ground, so that the nonlinear components may be prevented from flowing into the input terminal through parasitic components.

Transistor MN8 may have a drain connected to an output terminal, a seventh node n7, and a source connected to the sixth node n6. When the enable signal EN is applied to a gate of transistor MN8, transistor MN8 may be turned on in the first operation mode and turned off in the second operation mode.

In the first operation mode, transistor MN8 may be turned on to allow the unit amplification circuit 300 to amplify the input signal IN through transistor MN6. In the second operation mode, transistor MN8 may be turned off to block a DC current path to the output terminal to reduce power consumption.

The first compensation circuit 310a may be connected to the fifth node n5, an input terminal, and may be configured to compensate for the impedance change defined on the input terminal in the second operation mode. The second compensation circuit 310b may be connected to the seventh node n7, an output terminal, and may be configured to compensate for the impedance change defined on the output terminal in the second operation mode (the change in output impedance that otherwise occurs from the first operation mode to the second operation mode).

For example, the first compensation circuit 310a and the second compensation circuit 310b may be implemented in the same way as illustrated in FIG. 2A. For example, the first compensation circuit 310a may include a first compensation capacitor CS1 and a first compensation transistor MN4 connected to the fifth node n5. As described above, MN4 may be turned on in the second operation mode to allow capacitor CS1 to compensate for the input impedance change.

The second compensation circuit 310b may include the second compensation capacitor CS2 and the second compensation transistor MN5 connected to the seventh node n7. As described above, MN5 may be turned on in the second operation mode to allow capacitor CS2 to compensate for the output impedance change.

Each transistor included in the first compensation circuit 310a and the second compensation circuit 310b may also be implemented as a P-type transistor, as illustrated in FIG. 2B.

In the above-described embodiment of FIG. 6, the second compensation circuit 310b may be omitted depending on the implementation.

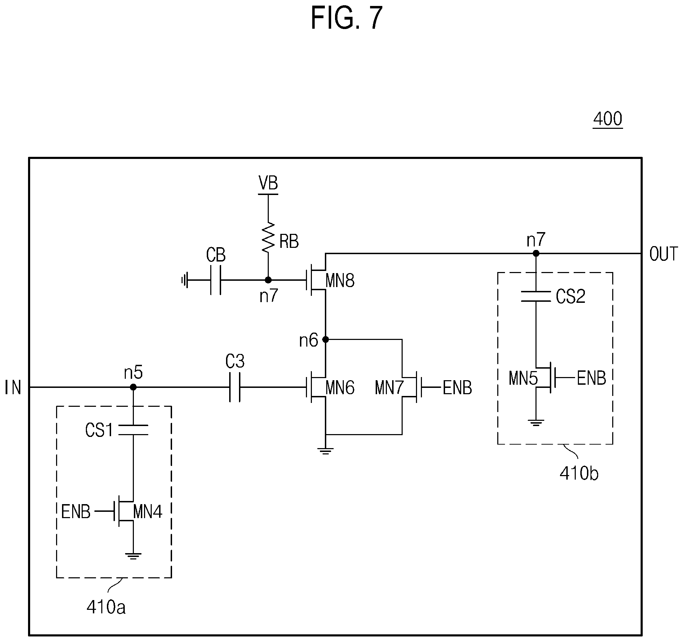

FIG. 7 is a diagram illustrating a unit amplification circuit having a cascade structure according to some example embodiments. Hereinafter, detailed descriptions that overlap those of FIG. 6 will be omitted.

Referring to FIG. 7, a unit amplification circuit 400 may be implemented with a cascade structure rather than the above-described push-pull structure according to FIG. 1 to FIG. 5. In an example embodiment, the unit amplification circuit 400 may include a fourth N-type transistor MN4 to an eighth N-type transistor MN8, a first compensation circuit 410a, and a second compensation circuit 410b, as illustrated. In an example embodiment, each compensation circuit may be implemented with a P-type transistor as well as an N-type transistor, as illustrated.

Instead of the enable signal EN of FIG. 6, elements for biasing may be connected to a gate of the eighth N-type transistor MN8. For example, a bias capacitor CB and a bias resistor RB may be connected to a seventh node n7 corresponding to the gate of transistor MN8. The bias capacitor CB may have one end connected to the seventh node n7 and the other terminal grounded. The bias voltage VB may be charged to the bias capacitor CB through the bias resistor RB or provide biasing to transistor MN8.

Transistor MN8 may be turned on or off depending on the biasing. For example, transistor MN8 may be turned on in the first operation mode and turned off in the second operation mode. Transistor MN8 may be turned off to block a DC current path to the output terminal in the second operation mode.

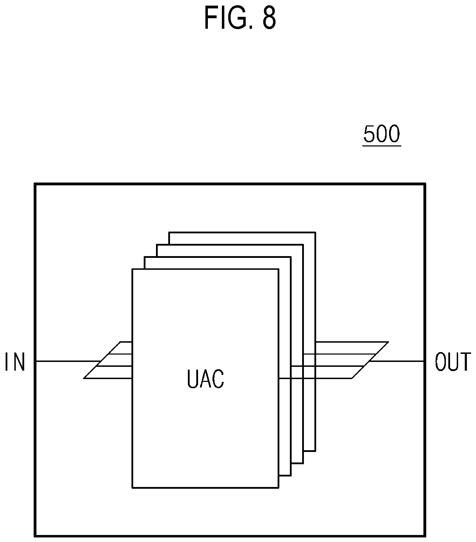

FIG. 8 is a diagram illustrating an amplifier according to some example embodiments.

Referring to FIG. 8, an amplifier 500 may include a plurality of unit amplification circuits UACs, each configured to operate with a first gain in a first operation mode and with a second, different gain in a second operation mode. (The second gain may be zero when the second operation mode is a deactivation mode, such that there is no output signal despite the continued application of the input signal.) Each of the plurality of unit amplification circuits UACs may be implemented as one of the above-described unit amplification circuits 100, 200, 300 or 400 of FIG. 1 to FIG. 7. The plurality of unit amplification circuits UACs may have the same transconductance (*gₘ*) or different transconductances (*gₘ*), respectively.

Each of the plurality of unit amplification circuits UACs may operate in either the first operation mode or the second operation mode. A unit amplification circuit UAC operating in the first operation mode may be turned on (or activated) to amplify the input signal IN based on a specific gain, and a unit amplification circuit UAC operating in the second operation mode may be turned off (or deactivated). Accordingly, the amplifier 500 may adjust the number of turned-on unit amplification circuits UACs to adjust a gain of the entire amplifier 500. As a result, the amplifier 500 may have a wide dynamic range and may consume less power when less gain is needed. A wide dynamic range may be understood as the ability to suitably amplify input signals that have a wide dynamic range, and/or to output amplified signals with a wide dynamic range, as needed.

For example, the amplifier 500 may turn on more unit amplification circuits UACs to increase gain, and may turn off more unit amplification circuits UACs to decrease gain.

In an example embodiment, the input impedance and/or output impedance of the amplifier 500 may change depending on the unit amplification circuit UAC that is turned on/off. In addition, a parameter S 1 1 (reflection coefficient) and a resonant frequency may also change depending on the impedance change. However, when the unit amplification circuit UAC is implemented according to example embodiments (for example, including the first compensation circuit and/or the second compensation circuit of FIG. 1 to FIG. 7), the impedance change that would otherwise occur may be compensated for, and the parameter S 1 1 and the resonant frequency may be maintained satisfactory as much as possible due to the compensation.

In addition, each turned-off unit amplification circuit UAC may reduce power consumption by blocking DC current through a path control circuit according to example embodiments (for example, the path control circuit of FIG. 1 to FIG. 7).

In addition, each turned-off unit amplification circuit UAC may ground a transistor, performing an amplification operation through a symmetric circuit according to example embodiments (for example, the symmetric circuit of FIG. 1 to FIG. 5 and the fifth transistor of FIG. 6 and FIG. 7) in an analog manner to prevent nonlinear components from flowing into the input terminal and degradation of linearity.

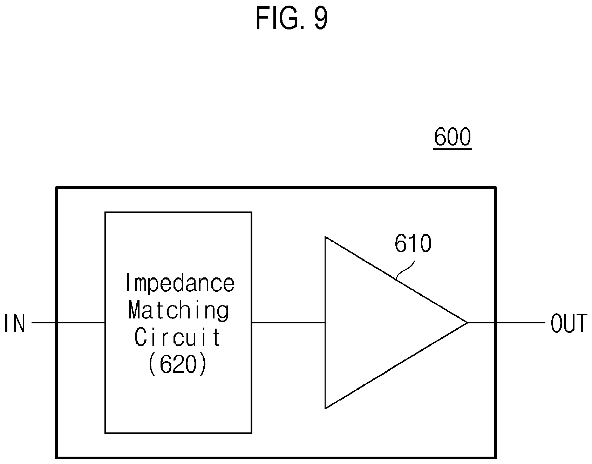

FIG. 9 is a diagram illustrating an amplification stage according to some example embodiments.

Referring to FIG. 9, an amplification stage 600 may include an amplifier 610 and an impedance matching circuit 620 connected to an input terminal of the amplifier 610.

The amplifier 610 may be implemented according to FIG. 8 described above. The impedance matching circuit 620 connected to an input terminal of the amplifier 610 may provide impedance matching to the amplifier 610. For example, the impedance matching circuit 620 may be implemented based on an LC tank, a transformer, or the like.

Separately from the impedance matching circuit 620, each unit amplification circuit (for example, FIG. 7) may include a compensation circuit for compensating for an impedance change (for example, the first compensation circuit and/or the second compensation circuit of FIGS. 1 to 6) according to the above-described embodiments. Accordingly, input/output terminal impedance of the amplifier 610, which may change when transitioning between modes of the unit amplification circuit being turned on or off, may also be compensated for.

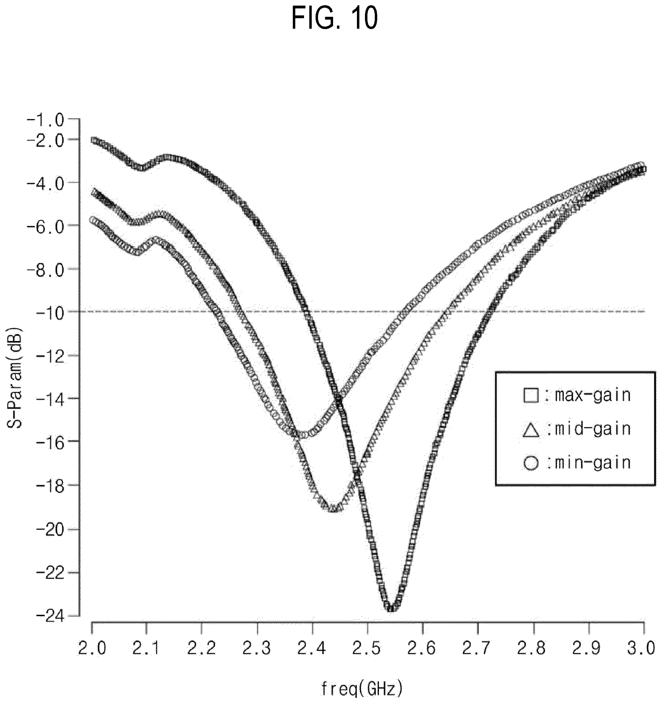

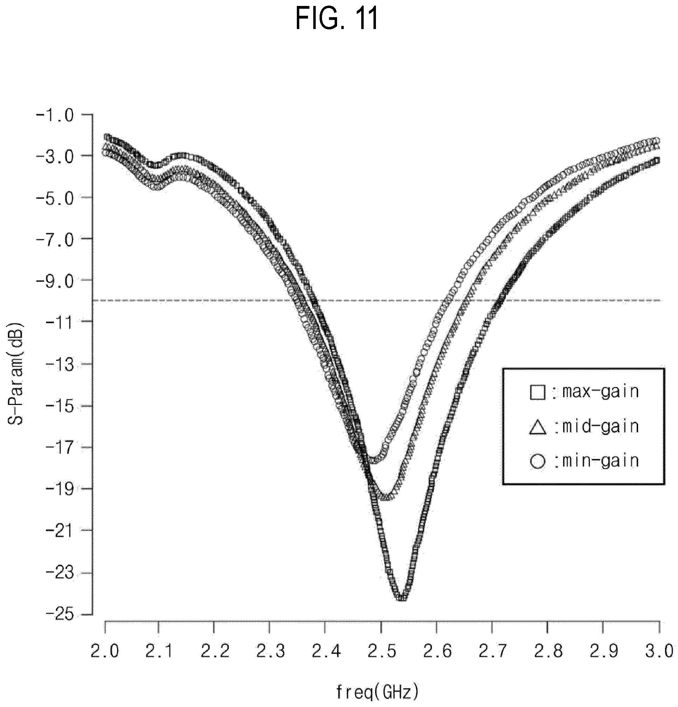

FIGS. 10 and 11 are diagrams illustrating comparison of parameters S11 (reflection coefficient) of an amplifier according to some example embodiments.

FIG. 10 illustrates an S11 simulation result for a conventional amplifier, and an example is provided in which the amplifier includes a push-pull circuit without the path control circuit, symmetric circuit and compensation circuits as taught herein. FIG. 11 illustrates an S11 simulation result for an amplifier according to some example embodiments, and an example is provided in which a band of a signal required for the amplifier (hereinafter referred to as a required band) is 2.4GHz to 2.5GHz.

When a gain is commonly changed to a maximum gain, a middle gain, and a minimum gain, a band range in which the parameter S11 is less than -10dB near the required band in FIG. 8 is about 2.39 GHz to 2.56 GHz. For example, a size of the band range in which the parameter S11 is less than -10dB in FIG. 10 is about 170MHz.

However, in FIG. 11, a band period in which the parameter S11 is less than - 10dB near the required band is about 2.38 GHz to 2.61 GHz and a size thereof is about 230MHz. Accordingly, it may be confirmed that the parameter S11, an input matching characteristic, may be improved when an impedance change is compensated for according to example embodiments.

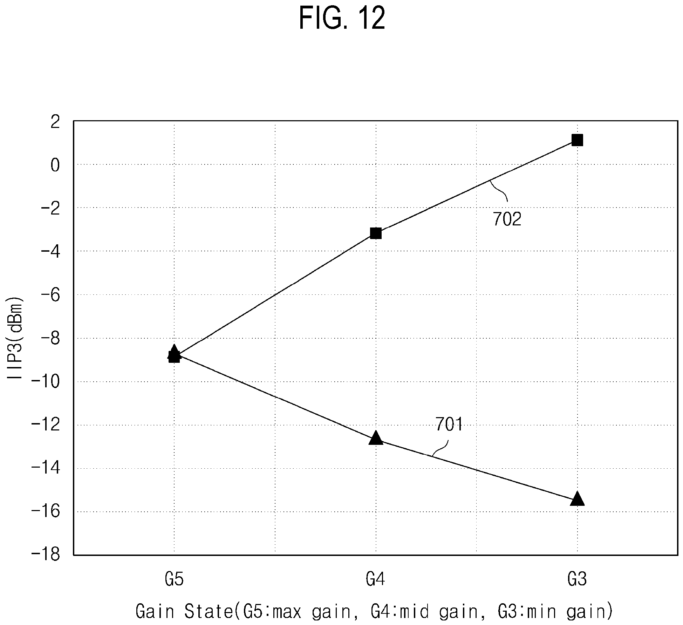

FIG. 12 is a diagram illustrating comparison of input-referred third-order intercept point (IIP3) parameters of an amplifier according to some example embodiments.

Referring to FIG. 12, in the case of a conventional amplifier denoted by curve 701 including a push-pull circuit, even if some unit amplification circuits are turned off when a gain is changed to a maximum gain, a middle gain, and a minimum gain, entering of nonlinear components may not be blocked. Accordingly, it may be confirmed that an IIP3 parameter exhibiting linearity deteriorates as the gain decreases.

In the case of an amplifier denoted by curve 702 according to some example embodiments, nonlinear components may be prevented from being fed back towards an input terminal according to the above-mentioned embodiments (for example, employing a symmetric circuit). For example, when a unit amplification circuit (e.g., 100) is turned off, gain of the turned-off unit amplification circuit may be zero and nonlinear components otherwise generated may be blocked. Accordingly, it may be confirmed that the IIP3 parameter exhibiting linearity is also improved.

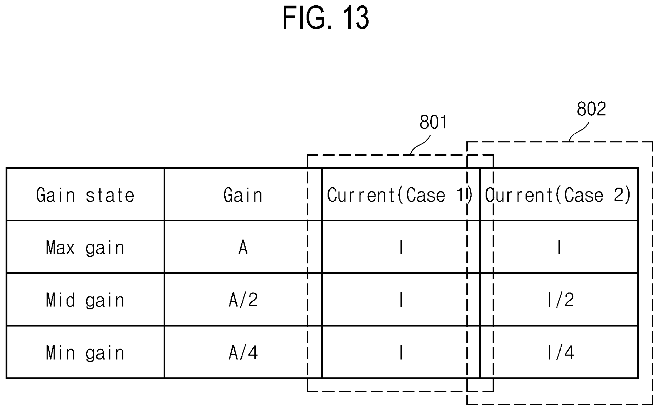

FIG. 13 is a table illustrating power consumption of an amplifier according to some example embodiments.

Referring to FIG. 13, in the case of a conventional amplifier corresponding to data 801 including a push-pull circuit, the same power consumption (an arbitrary real number I) may be maintained when a gain is changed to a maximum gain (an arbitrary real number A), a middle gain A/2, and a minimum gain A/4.

In the case of an amplifier corresponding to data 802 according to some example embodiments, direct current (DC) to an output terminal may be blocked in a second operation mode according to the above-mentioned embodiments (for example, a path control circuit). Accordingly, power consumption may also be reduced by the same ratio as the gain decreases.

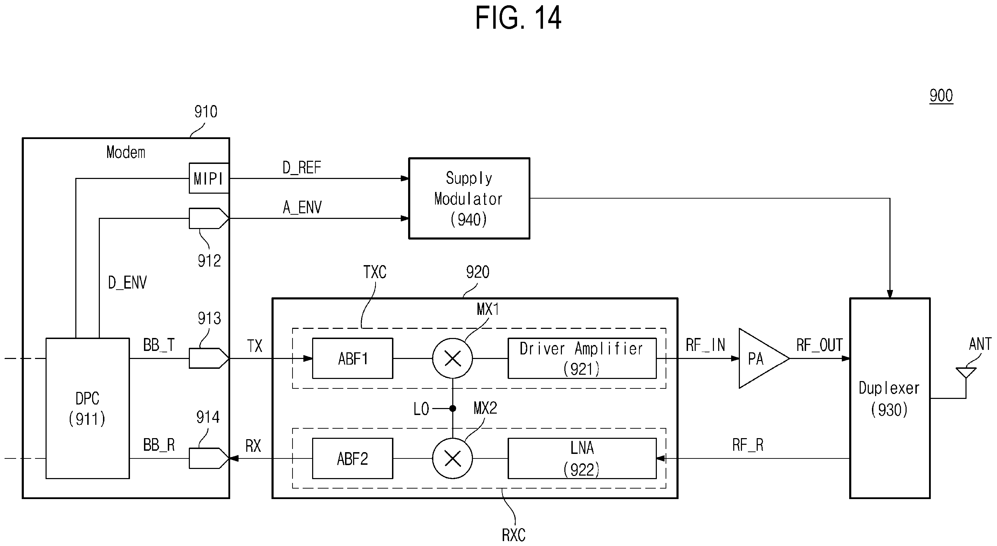

FIG. 14 is a diagram illustrating a wireless communication device according to some example embodiments.

Referring to FIG. 14, a wireless communication device 900 may include a modem 910, a radio-frequency integrated circuit (RFIC) 920, a power amplifier PA, a duplexer 930, a power modulator 940, and an antenna ANT.

The modem 910 may include a digital processing circuit 911, a first digital-to-analog converter (DAC) 912, a second DAC 913, an analog-to-digital Converter (ADC) 914, and a mobile industry processor interface (MIPI). The modem 910 may process a baseband signal BB_T (including, for example, an I signal and a Q signal) including information to be transmitted through the digital processing circuit 911 using various communication schemes. The modem 910 may process the received baseband signal BB_R through the digital processing circuit 911 using various communication schemes.

For example, the modem 910 may process a signal to be transmitted or a received signal using a communication scheme such as orthogonal frequency division multiplexing (OFDM), orthogonal frequency division multiple access (OFDMA), wideband code multiple access (WCDMA), high speed packet access+ (HSPA+), or the like. In addition, the modem 910 may process the baseband signal BB_T or BB_R using various communication schemes (for example, various communication schemes employing technology for modulating or demodulating the amplitude and frequency of the baseband signal BB_T or BB_R).

According to some example embodiments, the modem 910 may extract an envelope of the baseband signal BB_T through the digital processing circuit 911 and generate a digital envelope signal D_ENV based on the extracted envelope.

According to some example embodiments, the modem 910 may generate an average power signal D_REF based on an average power tracking (APT) table stored in a memory. The APT table may store preset power supply voltage information of a power amplifier PA based on expected output power (for transmitted power) of the antenna ANT, and may store information of an average power signal D_REF corresponding to the preset power supply voltage of the power amplifier PA. Accordingly, when the expected output power of the antenna ANT is determined, the modem 910 may generate the average power signal D_REF using the APT table and provide the generated average power signal D_REF to the power modulator 940 as a reference voltage signal.

The digital processing circuit 911 may perform various processing operations on the baseband signal in a digital domain.

For example, the digital processing circuit 911 may perform the above-described average power signal generation, as well as envelope extraction operation, digital envelope signal generation, crest factor reduction (CFR), shaping function (SF), digital pre-distortion (DPD), delay compensation operation, or the like.

CFR may reduce a peak-to-average power ratio (PAPR) of the communication signal (for example, the baseband signal BB_T). SF may modify the digital envelope signal D_ENV to improve efficiency and linearity of the power amplifier PA. DPD may compensate for and linearize a distortion of the power amplifier PA in the digital domain. In addition, the delay compensation operation may compensate for a delay of the digital envelope signal D_ENV or the baseband signal BB_T.

The digital processing circuit 911 may output the digital envelope signal D_ENV and the baseband signal BB_T. The digital envelope signal D_ENV may be converted into an analog envelope signal A_ENV through the first DAC 912 and then provided to the power modulator 940, and the baseband signal BB_T may be converted into a transmit signal TX through the second DAC 913 and provided to a transmit circuit TXC.

Although not illustrated in the drawings, the digital processing circuit 911 may include additional internal components performing the above-described operations (for example, baseband signal processing, envelope extraction, digital envelope signal generation, or the like).

The second DAC 913 and the ADC 914 may be provided in either singular or plural. The modem 910 may convert the baseband signal BB_T in an analog manner using the second DAC 913 to generate a transmit signal TX. In addition, the modem 910 may receive a receive signal RX, an analog signal, from the RFIC 920. The modem 910 may digitally convert the receive signal RX using the ADC 914 provided therein to extract the baseband signal BB_R, a digital signal. For example, the receive signal RX may be a differential signal including a positive signal and a negative signal.

The RFIC 920 may perform up-conversion on the transmit signal TX to generate an RF input signal RF_IN, or perform down-conversion on the RF receive signal RF_R to generate a receive signal RX. For example, the RFIC 920 may include a transmit circuit TXC for up-conversion, a receive circuit RXC for down-conversion, and a local oscillator LO.

The transmit circuit TXC may include a first analog baseband filter ABF1, a first mixer MX1, and a driver amplifier 921. For example, the first analog baseband filter ABF1 may include a low pass filter.

The baseband filter ABF1 may filter the transmit signal TX, received from the modem 910, and provide the filtered transmit signal TX to the first mixer MX1. For example, the baseband filter ABF1 may filter the baseband signal. The first mixer MX1 may perform up-conversion to convert a frequency of the transmit signal TX from a baseband to a high-frequency band using an LO signal provided by the local oscillator LO. As described above, the up-conversion may allow the transmit signal TX to be provided to the driver amplifier 921 as the RF input signal RF_IN, and the driver amplifier 921 may perform first power amplification on the RF input signal and provide the amplified RF input signal to the power amplifier PA.

The power amplifier PA may receive a DC voltage or a variable power supply voltage (for example, a dynamically varying output voltage), and may perform second amplification on power of the RF input signal RF_IN based on the received power supply voltage to generate an RF output signal RF_OUT. The power amplifier PA may provide the generated RF output signal RF_OUT to the duplexer 930.

The receive circuit RXC may include a second analog baseband filter ABF2, a second mixer MX2, and a low-noise amplifier (LNA) 922. For example, the second analog baseband filter ABF2 may include a low pass filter.

The LNA 922 may amplify the RF receive signal RF_R, received from the duplexer 930, and provide the amplified RF receive signal RF_R to the second mixer MX2. The second mixer MX2 may perform down-conversion to convert a frequency of the receive signal RF_R from a high-frequency band to a baseband using an LO signal provided by the local oscillator LO. For example, the second mixer MX2 may convert the RF receive signal RF_R into a baseband signal using an LO signal.

The down-conversion may allow the RF receive signal RF_R corresponding to the baseband signal to be provided to the second analog baseband filter ABF2 as a receive signal RX, and the second analog baseband filter ABF2 may filter the receive signal RX corresponding to the baseband signal and provide the filtered receive signal RX to the modem 910.

In embodiments, the wireless communication device 900 may transmit a transmit signal over a plurality of frequency bands using carrier aggregation (CA) technology. Also, for this purpose, the wireless communication device 900 may include a plurality of power amplifiers PAs, respectively amplifying a plurality of RF input signals RF_IN corresponding to a plurality of carriers. In the present embodiment, for ease of description, an example will be provided in which a single power amplifier PA is provided.

The duplexer 930 may be connected to the antenna ANT to separate a transmit frequency and a receive frequency. For example, the duplexer 930 may separate the RF output signal RF_OUT, provided from the power amplifier PA, for each frequency band and provide the separated output signal RF_OUT to a corresponding antenna ANT. In addition, the duplexer 930 may provide an external signal received from the antenna ANT to the LNA 922 included in the RF circuit 922 of the receive circuit RXC of the RFIC 920. For example, the duplexer 930 may include a front end module with integrated duplexer (FEMiD).

In embodiments, the wireless communication device 900 may be provided with a switch structure to separate the transmit frequency and the receive frequency, instead of the duplexer 930. In addition, the wireless communication device 900 may be provided with a structure including a duplexer 930 and a switch to separate the transmit frequency and the receive frequency. In the present embodiment, for ease of description, an example will be provided in which the wireless communication device 900 is provided with the duplexer 930 to separate the transmit frequency and the receive frequency.

The power modulator 940 may generate a modulated output voltage having a dynamically varying level based on an analog envelope signal A_ENV and an average power signal D_REF, and may provide an output voltage as a supply voltage of the power amplifier PA.

For example, the power modulator 940 may receive the average power signal D_REF and the analog envelope signal A_ENV from the modem 910. The power modulator 940 may be driven in either ET mode or APT mode as a tracking mode based on the received average power signal D_REF and analog envelope signal A_ENV to generate a dynamically varying output voltage. In addition, the power modulator 940 may provide the generated output voltage to the power amplifier PA as a power supply voltage.

In general, when a power supply voltage having a fixed level is applied to the power amplifier PA, the power efficiency of the power amplifier PA may be reduced. Accordingly, the power modulator 940 may modulate an input voltage (power supplied from a battery) based on at least one of the analog envelope signal A_ENV and the average power signal D_REF and provide the modulated voltage to the power amplifier PA as a power supply voltage to efficiently manage the power of the power amplifier PA.

The antenna ANT may transmit a frequency-separated RF output signal RF_OUT to an external entity or provide an externally received RF receive signal RF_R to the duplexer 930. For example, the antenna ANT may include an array antenna, but example embodiments are not limited thereto.

In embodiments, the modem 910, the RFIC 920, the power amplifier PA, the duplexer 930, and the power modulator 940 may each be individually implemented as an IC, a chip, or a module. The modem 910, the RFIC 920, the power amplifier PA, the duplexer 930, and the power modulator 940 may also be mounted together on a printed circuit board (PCB). However, example embodiments are not limited thereto and, in some embodiments, at least a portion of the modem 910, the RFIC 920, the power amplifier PA, the duplexer 930, and the power modulator 940 may be implemented as a single communication chip.

At least one of the driver amplifier 921, the LNA 922, and the power amplifier PA, included in the above-described wireless communication device and performing an amplification operation, may be implemented as a unit amplification circuit and an amplifier according to the embodiments of FIGS. 1 to 8, or as an amplifier stage according to the embodiment of FIG. 9. In an example embodiment, the driver amplifier 921, the LNA 922, and the power amplifier PA may adjust a gain for amplification by turning on or off a plurality of unit amplification circuits. In addition, an impedance change caused by turning on or off a plurality of unit amplification circuits may be compensated for. When the plurality of unit amplification circuits are turned off, a DC path may be blocked to reduce power consumption. In addition, when the plurality of unit amplification circuits are turned off, nonlinear signal components of a transistor may be prevented from being fed back to an input terminal (and thereby prevented from entering an input terminal of another unit amplification circuit).

For example, the LNA 922 included in the receive circuit RXC in the RFIC 920 may have a relatively high proportion of power consumption. In an example embodiment, in the case in which the LNA 922 is implemented to block the DC path when the unit amplifier circuit is turned off according to some example embodiments, the power consumption may be reduced more effectively.

Furthermore, the wireless communication device 900 illustrated in FIG. 14 may be included in a wireless communication system using a cellular network such as 5G or LTE, or may be included in a wireless local area network (WLAN) system or another arbitrary wireless communication system. For reference, the configuration of the wireless communication device 900 illustrated in FIG. 14 is only an example embodiment, and example embodiments are not limited thereto. The configuration of the wireless communication device may vary depending on a communication protocol or a communication scheme.

As set forth above, according to example embodiments, a unit amplification circuit having improved amplification-related characteristics, an amplifier, and a receiving circuit may be provided.

While example embodiments have been shown and described above, it will be apparent to those skilled in the art that modifications and variations could be made without departing from the scope of the present inventive concept as defined by the appended claims.

Embodiments are set out in the following clauses:
Clause 1: A unit amplification circuit comprising:
   a push-pull circuit having a transistor with a gate connected to an input terminal;
   a symmetrical circuit connected symmetrically to the push-pull circuit and configured to be turned off in a first operation mode and turned on in a second operation mode; and
   a path control circuit connected to a drain of the transistor and configured to connect the drain and an output terminal in the first operation mode and to disconnect the drain and the output terminal in the second operation mode.
Clause 2: The unit amplification circuit of clause 1, wherein the push-pull circuit comprises:
   a first N-type transistor having a gate, connected to the input terminal through a first capacitor, and a source grounded; and
   a first P-type transistor having a gate, connected to the input terminal through a second capacitor, and a source from which a power supply voltage is supplied,
   wherein the transistor with a gate connected to the input terminal is one of the first N-type transistor or the first P-type transistor.
Clause 3: The unit amplification circuit of clause 2, wherein the symmetrical circuit comprises:
   a second N-type transistor connected symmetrically to the first N-type transistor and configured to be turned off in the first operation mode and turned on in the second operation mode; and
   a second P-type transistor connected symmetrically to the first P-type transistor and configured to be turned off in the first operation mode and turned on in the second operation mode.
Clause 4: The unit amplification circuit of clause 2, wherein in the second operation mode, the symmetrical circuit is configured to ground a drain of the first N-type transistor and connect a drain of the first P-type transistor to the power supply voltage.
Clause 5: The unit amplification circuit of clause 3 or 4, wherein the path control circuit comprises:
   a third N-type transistor having a source connected to a drain of the first N-type transistor and configured to be turned on in the first operation mode and turned off in the second operation mode; and
   a third P-type transistor having a source connected to a drain of the first P-type transistor and configured to be turned on in the first operation mode and turned off in the second operation mode.
Clause 6: The unit amplification circuit of any preceding clause, further comprising:
   a first compensation circuit connected to the input terminal and configured to compensate for an impedance change defined on the input terminal, from an input impedance in the first operation mode to an input impedance the second operation mode.
Clause 7: The unit amplification circuit of clause 6, wherein
   the first compensation circuit comprises:
   a first compensation capacitor connected to the input terminal; and
   a first compensation transistor having a drain connected to the first compensation capacitor and configured to be turned off in the first operation mode and turned on in the second operation mode.
Clause 8: The unit amplification circuit of clause 6 or 7, further comprising:
   a second compensation circuit connected to the output terminal and configured to compensate for an impedance change defined on the output terminal, from an output impedance in the first operation mode to an output impedance in the second operation mode.
Clause 9: The unit amplification circuit of clause 8, wherein
   the second compensation circuit comprises:
   a second compensation capacitor connected to the output terminal; and
   a second compensation transistor having a drain connected to the second compensation capacitor and configured to be turned off in the first operation mode and turned on in the second operation mode.
Clause 10: The unit amplification circuit of any preceding clause, wherein the push-pull circuit is configured to amplify an input signal applied to the input terminal and output the amplified signal to the output terminal, in the first operation mode, and to be deactivated in the second operation mode.
Clause 11: An amplifier comprising:
   a plurality of unit amplification circuits, each configured to operate with a respective gain in a first operation mode and with a different respective gain in a second operation mode,
   wherein,
   each of the plurality of unit amplification circuits comprises:
      a push-pull circuit having a transistor with a gate connected to an input terminal;
      a symmetrical circuit connected symmetrically to the push-pull circuit and configured to be turned off in the first operation mode and turned on in the second operation mode; and
      a path control circuit connected to a drain of the transistor and configured to connect the drain to an output terminal in the first operation mode and to disconnect the drain from the output terminal in the second operation mode.
Clause 12: The amplifier of clause 11, wherein the input terminal and the output terminal are commonly connected to the plurality of unit amplification circuits.
Clause 13: The amplifier of clause 11 or 12, wherein each of the plurality of unit amplification circuits is configured to amplify an input signal applied to the input terminal and output the amplified signal to the output terminal, in the first operation mode.
Clause 14: The amplifier of any of clauses 11 to 13, further comprising:
   an impedance matching circuit connected to the input terminal for impedance matching.
Clause 15: The amplifier of any of clauses 11 to 14, wherein
   the push-pull circuit comprises:
      a first N-type transistor having a gate, connected to the input terminal through a first capacitor, and a source grounded; and
      a first P-type transistor having a gate, connected to the input terminal through a second capacitor, and a source from which a power supply voltage is supplied, wherein the transistor with a gate connected to the input terminal is one of the first N-type transistor or the first P-type transistor; and
   the symmetrical circuit comprises:
      a second N-type transistor connected symmetrically to the first N-type transistor and configured to be turned off in the first operation mode and turned on in the second operation mode; and
      a second P-type transistor connected symmetrically to the first P-type transistor and configured to be turned off in the first operation mode and turned on in the second operation mode.
Clause 16: The amplifier of clause 15, wherein
   the path control circuit comprises:
      a third N-type transistor having a source connected to a drain of the first N-type transistor and configured to be turned on in the first operation mode and turned off in the second operation mode; and
      a third P-type transistor having a source connected to a drain of the first P-type transistor and configured to be turned on in the first operation mode and turned off in the second operation mode.
Clause 17: The amplifier of any of clauses 11 to 16, wherein
   each of the plurality of unit amplification circuits further comprises:
   a first compensation circuit connected to the input terminal and configured to compensate for an impedance change defined on the input terminal in the second operation mode.
Clause 18: A receiving circuit comprising:
   an amplifier configured to amplify a receive signal through a plurality of unit amplification circuits, each configured to operate with a respective gain in a first operation mode and with a different respective gain in a second operation mode;
   a mixer configured to convert the receive signal into a baseband signal through a local oscillator (LO) signal; and
   an analog baseband filter configured to filter the baseband signal, wherein,
   each of the plurality of unit amplification circuits comprises:
      a push-pull circuit having a transistor with a gate to which the receive signal is applied;
      a symmetrical circuit connected symmetrically to the push-pull circuit and configured to be turned off in the first operation mode and turned on in the second operation mode; and
      a path control circuit connected to a drain of the transistor and configured to connect the drain to the mixer in the first operation mode and to disconnect the drain from the mixer in the second operation mode.
Clause 19: The receiving circuit of clause 18, wherein
   the push-pull circuit comprises:
   a first N-type transistor having a gate, to which the receive signal is applied through a first capacitor, and a source grounded; and
   a first P-type transistor having a gate, to which the receive signal is applied through a second capacitor, and a source from which a power supply voltage is supplied.
Clause 20: The receiving circuit of clause 19, wherein
   the symmetrical circuit comprises:
   a second N-type transistor connected symmetrically to the first N-type transistor and configured to be turned off in the first operation mode and turned on in the second operation mode; and
   a second P-type transistor connected symmetrically to the first P-type transistor and configured to be turned off in the first operation mode and turned on in the second operation mode.
Clause 21: A unit amplification circuit configured to operate in an amplification mode and a deactivation mode, the unit amplification circuit comprising:
   a push-pull circuit comprising first and second transistors, each having a gate that is alternating current (AC) coupled to an input terminal, and each having a pair of conducting terminals;
   a symmetrical circuit connected symmetrically to the push-pull circuit and configured to be turned off in the amplification mode and turned on in the deactivation mode; and
   a path control circuit connected to the first and second transistors and configured to close respective circuit paths between one of the pair of conducting terminals of each of the first and second transistors to an output terminal in the amplification mode, and to open the respective circuit paths in the deactivation mode.

## Claims

1. A unit amplification circuit comprising:
a push-pull circuit having a transistor with a gate connected to an input terminal;
a symmetrical circuit connected symmetrically to the push-pull circuit and configured to be turned off in a first operation mode and turned on in a second operation mode; and
a path control circuit connected to a drain of the transistor and configured to connect the drain and an output terminal in the first operation mode and to disconnect the drain and the output terminal in the second operation mode.

2. The unit amplification circuit of claim 1, wherein the push-pull circuit comprises:
a first N-type transistor having a gate, connected to the input terminal through a first capacitor, and a source grounded; and
a first P-type transistor having a gate, connected to the input terminal through a second capacitor, and a source from which a power supply voltage is supplied,
wherein the transistor with a gate connected to the input terminal is one of the first N-type transistor or the first P-type transistor.

3. The unit amplification circuit of claim 2, wherein the symmetrical circuit comprises:
a second N-type transistor connected symmetrically to the first N-type transistor and configured to be turned off in the first operation mode and turned on in the second operation mode; and
a second P-type transistor connected symmetrically to the first P-type transistor and configured to be turned off in the first operation mode and turned on in the second operation mode.

4. The unit amplification circuit of claim 2, wherein in the second operation mode, the symmetrical circuit is configured to ground a drain of the first N-type transistor and connect a drain of the first P-type transistor to the power supply voltage.

5. The unit amplification circuit of claim 3 or 4, wherein the path control circuit comprises:
a third N-type transistor having a source connected to a drain of the first N-type transistor and configured to be turned on in the first operation mode and turned off in the second operation mode; and
a third P-type transistor having a source connected to a drain of the first P-type transistor and configured to be turned on in the first operation mode and turned off in the second operation mode.

6. The unit amplification circuit of any preceding claim, further comprising:
a first compensation circuit connected to the input terminal and configured to compensate for an impedance change defined on the input terminal, from an input impedance in the first operation mode to an input impedance the second operation mode.

7. The unit amplification circuit of claim 6, wherein
the first compensation circuit comprises:
a first compensation capacitor connected to the input terminal; and
a first compensation transistor having a drain connected to the first compensation capacitor and configured to be turned off in the first operation mode and turned on in the second operation mode.

8. The unit amplification circuit of claim 6 or 7, further comprising:
a second compensation circuit connected to the output terminal and configured to compensate for an impedance change defined on the output terminal, from an output impedance in the first operation mode to an output impedance in the second operation mode.

9. The unit amplification circuit of claim 8, wherein
the second compensation circuit comprises:
a second compensation capacitor connected to the output terminal; and
a second compensation transistor having a drain connected to the second compensation capacitor and configured to be turned off in the first operation mode and turned on in the second operation mode.

10. The unit amplification circuit of any preceding claim, wherein the push-pull circuit is configured to amplify an input signal applied to the input terminal and output the amplified signal to the output terminal, in the first operation mode, and to be deactivated in the second operation mode.

11. An amplifier comprising:
a plurality of the unit amplification circuits of any preceding claim, each configured to operate with a respective gain in a first operation mode and with a different respective gain in a second operation mode.

12. The amplifier of claim 11, wherein the input terminal and the output terminal are commonly connected to the plurality of unit amplification circuits.

13. The amplifier of claim 11 or 12, wherein each of the plurality of unit amplification circuits is configured to amplify an input signal applied to the input terminal and output the amplified signal to the output terminal, in the first operation mode.

14. An amplification stage comprising:
the amplifier of any of claims 11 to 13; and
an impedance matching circuit connected to the input terminal for impedance matching.

15. A receiving circuit comprising:
an amplifier configured to amplify a receive signal through a plurality of the unit amplification circuits of any of claims 1 to 10, each configured to operate with a respective gain in a first operation mode and with a different respective gain in a second operation mode;
a mixer configured to convert the receive signal into a baseband signal through a local oscillator (LO) signal; and
an analog baseband filter configured to filter the baseband signal.
